# EUROPEAN PATENT APPLICATION

(11) **EP 4 776 788 A1**
(43) Date of publication of application: **15.07.2026**
(21) Application number: 25151232.3
(22) Date of filing: 10.01.2025
(51) Int. Cl.: H10D 30/66, H10D 84/00, H10D 30/01, H10D 64/00

(54) **PILLAR TRENCH POWER MOSFET AND A METHOD OF MANUFACTURING THEREOF**

(71) Applicant: Huawei Technologies Co., Ltd., Shenzhen, Guangdong 518129 (CN)
(72) Inventor: CHANG, Mo Huai, 80992 Munich (DE); HE, Junqing, 80992 Munich (DE); HE, Linrong, 80992 Munich (DE)
(74) Representative: Goddar, Heinz J.

(57) **Abstract**

In some examples, a method of manufacturing a metal-oxide-semiconductor field-effect transistor (MOSFET) comprises forming multiple pillar trenches in a semiconductor substrate, wherein each pillar trench comprises a pillar trench source electrode and a field oxide material surrounding the source electrode, recessing the field oxide material in an upper portion of each pillar trench, whereby to form a recessed portion, and filling the recessed portion with a gate electrode, whereby to form a pillar trench gate electrode, forming multiple shallow trenches in a mesa region, wherein the mesa region comprises a region between two neighbouring pillar trenches, wherein each shallow trench comprises a shallow trench gate electrode, and wherein the shallow trench gate is formed by recessing the semiconductor substrate in the mesa region to define the shallow trench, and filling the shallow trench with a gate electrode material, whereby to form the shallow trench gate electrode, electrically connecting the pillar trench gate electrodes to the shallow trench gate electrodes via a gate pick-up, selectively converting at least one of the multiple pillar trenches, the shallow trenches, or both the multiple pillar trenches and the shallow trenches into a MOS diode structure by: replacing the pillar trench gate electrode, the shallow trench gate electrode, or both the pillar trench gate electrode and the shallow trench gate electrode, respectively, with a further source electrode, and forming a gate dielectric in the MOS diode structure.

## Description

### TECHNICAL FIELD

The present disclosure relates, in general, to metal-oxide-semiconductor field-effect transistors (MOSFETs). Aspects of the disclosure relate to MOSFETs comprising metal-oxide-semiconductor (MOS)-gated diodes.

### BACKGROUND

Silicon trench power MOSFETs have been an industry standard for over three decades, having largely replaced their planar counterparts due to their superior performance and their widespread applicability in industrial applications. The trench design offers several advantages over planar MOSFETs, including higher efficiency, faster switching speeds, reduced gate charge, improved on-resistance per unit area, greater current-handling capability, and significantly lower switching losses. These features have cemented trench power MOSFETs as a cornerstone of modern power electronics.

One critical performance parameter for power MOSFETs is the reverse recovery charge (*Qrr*), which is the charge that flows through the body diode during reverse recovery. A low *Qrr* is particularly desirable, as it reduces energy losses and improves switching efficiency. Several approaches have been explored to reduce *Qrr.* Process-side improvements include methods such as platinum diffusion, hydrogen implantation, or electron irradiation, which introduce recombination centres below the body junction to enhance carrier recombination during reverse recovery. While effective, such process-side solutions may increase manufacturing complexity and costs.

Alternatively, device-side improvements have been developed to reduce Qrr by integrating unipolar devices, such as Schottky diodes or MOS-gated diodes (MGDs), into the MOSFET structure. Unipolar devices have the advantage of eliminating carrier recombination, which can significantly reduce Qrr. In particular, the integration of MGDs has attracted attention due to their effectiveness in improving reverse recovery performance. MGDs typically replace the gate electrode in specific trenches with a source electrode, and their gate dielectric is thinner than that of the MOSFET trenches. This thinner gate dielectric results in a lower voltage drop during reverse recovery. By directing the reverse current through the MGD structure, reverse recovery losses are mitigated. The voltage drop in the MGD can be further tuned by adjusting the thickness of its gate dielectric, allowing for tailored performance depending on the application.

Despite their benefits, conventional integration methods for MGDs introduce several design and performance trade-offs. In traditional stripe layouts, active trenches are selectively converted into MGD structures to achieve the desired reverse recovery performance. For example, a stripe layout may feature one MGD trench for every four active MOSFET trenches. However, this approach comes with a significant penalty in on-resistance because active trench areas must be sacrificed to accommodate the MGDs. Additionally, once an active trench is converted to an MGD, the entire stripe is affected, making it difficult to fine-tune the ratio of MGD to active MOSFET area. This lack of granularity can limit optimisation for specific performance requirements.

State-of-the-art grid-like layouts, such as those employed in needle trench designs, have sought to address some of the limitations of traditional stripe layouts. These grid-like layouts interconnect all gate trenches to form a unified gate structure. While this approach can improve device scalability and uniformity, it precludes the integration of MGDs. The interconnected nature of the gate trenches in grid-like layouts prevents selective conversion of specific trenches into source electrodes, eliminating the possibility of incorporating MGDs into these designs. This restriction further complicates efforts to achieve a low *Qrr* while maintaining optimal device performance.

### SUMMARY

In view of the above, this disclosure aims to provide an improved MOSFET and a method of manufacturing thereof. An objective of the present disclosure is to reduce the on-resistance. Another objective is to provide more accurate/precise MOSFET design. Yet another objective is to reduce a voltage drop across the body diode and reverse recovery losses, and to achieve a desired voltage drop for target application operation scenario.

The foregoing and other objectives are achieved by the features of the independent claims.

Further implementation forms are apparent from the dependent claims, the description and the Figures.

A first aspect of the present disclosure provides a method of manufacturing a metal-oxide-semiconductor field-effect transistor, MOSFET, the method comprising forming multiple pillar trenches in a semiconductor substrate, wherein each pillar trench comprises a pillar trench source electrode and a field oxide material surrounding the source electrode, recessing the field oxide material in an upper portion of each pillar trench, whereby to form a recessed portion, and filling the recessed portion with a gate electrode, whereby to form a pillar trench gate electrode, forming multiple shallow trenches in a mesa region, wherein the mesa region comprises a region between two neighbouring pillar trenches, wherein each shallow trench comprises a shallow trench gate electrode, and wherein the shallow trench gate is formed by recessing the semiconductor substrate in the mesa region to define the shallow trench, and filling the shallow trench with a gate electrode material, whereby to form the shallow trench gate electrode, electrically connecting the pillar trench gate electrodes to the shallow trench gate electrodes via a gate pick-up, selectively converting at least one of the multiple pillar trenches, the shallow trenches, or both the multiple pillar trenches and the shallow trenches into a MOS diode structure by: replacing the pillar trench gate electrode, the shallow trench gate electrode, or both the pillar trench gate electrode and the shallow trench gate electrode, respectively, with a further source electrode, and forming a gate dielectric in the MOS diode structure.

Accordingly, the solution described herein offers a much smaller ON-resistance penalty compared to solutions available in the prior art. Furthermore, by parallelling the MOSFET(s) and the MOS-gated diode, the voltage drop across the body diode can be reduced, thus minimising reverse recovery losses. The solution described herein offers an uncomplicated layout and makes efficient use of the die area. By providing an ability to convert any trench gate electrode into a MOS diode structure, the solution enables more accurate and more precise design.

The gate pick-up may comprise a star-shaped gate pick-up.

The method may further comprise, in response to selectively converting at least one of the multiple pillar trenches, the shallow trenches, or both the multiple pillar trenches and the shallow trenches into the MOS diode structure, modifying the star-shaped gate pick-up by isolating the portions of the gate pick-up corresponding to the converted MOS diode structures, wherein isolating the portions of the gate pick-up comprises removing conductive paths in the gate pick-up directly above the MOS diode structures; and routing the remaining gate pick-up portions to maintain electrical connection only between unconverted gate electrodes of the pillar trench gate electrodes and the shallow trench gate electrodes.

The method may further comprise forming a gate dielectric along sidewalls of the recessed portion of each pillar trench and sidewalls of each shallow trench prior to filling with the gate electrode, wherein the gate dielectric within the MOS diode structure is thinner than the gate dielectric of the multiple pillar trenches and the multiple shallow trenches.

The method may further comprise adjusting a thickness of the gate dielectric within the MOS diode structure, whereby to achieve a specific voltage drop across a body junction of the MOS diode structure.

The method may further comprise forming a contact to electrically connect the source electrode in the MOS diode structure to a metal layer disposed on the surface of the semiconductor substrate

A second aspect of the present disclosure provides a metal-oxide-semiconductor field-effect transistor (MOSFET) comprising multiple pillar trenches, wherein each of the multiple pillar trenches comprises a source electrode surrounded by field oxide and a recessed upper portion comprising a pillar trench gate electrode, a mesa region comprising a region between two neighbouring pillar trenches of the multiple pillar trenches, wherein the mesa region comprises multiple shallow trenches, wherein each shallow trench of the multiple shallow trenches comprises a shallow trench gate electrode, a star-shaped gate pickup arranged to electrically connect each one of the pillar trench gate electrodes to the shallow trench gate electrodes, wherein at least one of the multiple pillar trenches, the shallow trenches, or both the multiple pillar trenches and the shallow trenches comprises a MOS diode structure, wherein each of the MOS diode structures comprises: a source electrode in place of: the pillar trench gate electrode, the shallow trench gate electrode, or both the pillar trench gate electrode and the shallow trench gate electrode, respectively, and a gate dielectric.

The MOS diode structure may be electrically connected in parallel to the multiple pillar trenches and the multiple shallow trenches.

The MOSFET may further comprise a gate dielectric disposed along the sidewalls of the recessed portion of each pillar trench and along the sidewalls of each shallow trench, wherein the gate dielectric within the MOS diode structure is thinner than the gate dielectric in the multiple pillar trenches and the multiple shallow trenches.

A threshold voltage of the MOS diode structure may be lower than a threshold voltage of the multiple pillar trenches and the multiple shallow trenches.

The gate pick-up may comprise a star-shaped gate pick-up.

Each pillar trench may comprise a split-gate structure, the split-gate structure comprising a first gate region positioned along a first sidewall of the pillar trench, and a second gate region positioned along an opposing sidewall of the pillar trench, wherein the first and second gate regions are independently controllable to form separate conductive channels along the respective sidewalls, thereby providing dual-gate control over a current flow through the pillar trench.

The MOSFET may further comprise a contact electrically connecting the source electrode in each MOS diode structure to a metal layer disposed on a surface of the semiconductor substrate, wherein the metal layer forms a source terminal for the MOSFET.

The MOS diode structure may be formed by converting at least one of the multiple pillar trenches, at least one of the multiple shallow trenches or both the multiple pillar trenches and the multiple shallow trenches into a MOS-gated diode.

A third aspect of the present disclosure provides a chip system comprising a plurality of MOSFETs as described herein, wherein the pillar trenches and/or the shallow gate trenches in some or all of the MOSFETs comprise MOS diode structures.

These and other aspects of the invention will be apparent from the embodiment(s) described below.

### BRIEF DESCRIPTION OF THE DRAWINGS

In order that the present invention may be more readily understood, embodiments of the invention will now be described, by way of example, with reference to the accompanying drawings, in which:
Figure 1 is a flow chart of a method of manufacturing a metal-oxide-semiconductor field-effect transistor (MOSFET) according to an example;
Figure 2a is a schematic representation of a metal-oxide-semiconductor field-effect transistor according to a first example;
Figure 2b is another schematic representation of a metal-oxide-semiconductor field-effect transistor according to a first example;
Figure 2c is a cross-section view of a metal-oxide-semiconductor field-effect transistor according to a first example;
Figure 3a is a schematic representation of a metal-oxide-semiconductor field-effect transistor according to a second example;
Figure 3b is another schematic representation of a metal-oxide-semiconductor field-effect transistor according to a second example;
Figure 3c is a cross-section view of a metal-oxide-semiconductor field-effect transistor according to a second example;
Figure 4a is a schematic representation of a metal-oxide-semiconductor field-effect transistor according to a third example;
Figure 4b is another schematic representation of a metal-oxide-semiconductor field-effect transistor according to a third example; and
Figure 4c is a cross-section view of a metal-oxide-semiconductor field-effect transistor according to a third example.

### DETAILED DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

Examples in the present disclosure can be provided as methods, systems or machine-readable instructions, such as any combination of software, hardware, firmware or the like. Such machine-readable instructions may be included on a computer readable storage medium (including but not limited to disc storage, CD-ROM, optical storage, etc.) having computer readable program codes therein or thereon.

The present disclosure is described with reference to flow charts and/or block diagrams of the method, devices and systems according to examples of the present disclosure. Although the flow diagrams described above show a specific order of execution, the order of execution may differ from that which is depicted. Blocks described in relation to one flow chart may be combined with those of another flow chart. In some examples, some blocks of the flow diagrams may not be necessary and/or additional blocks may be added. It shall be understood that each flow and/or block in the flow charts and/or block diagrams, as well as combinations of the flows and/or diagrams in the flow charts and/or block diagrams can be realized by machine readable instructions.

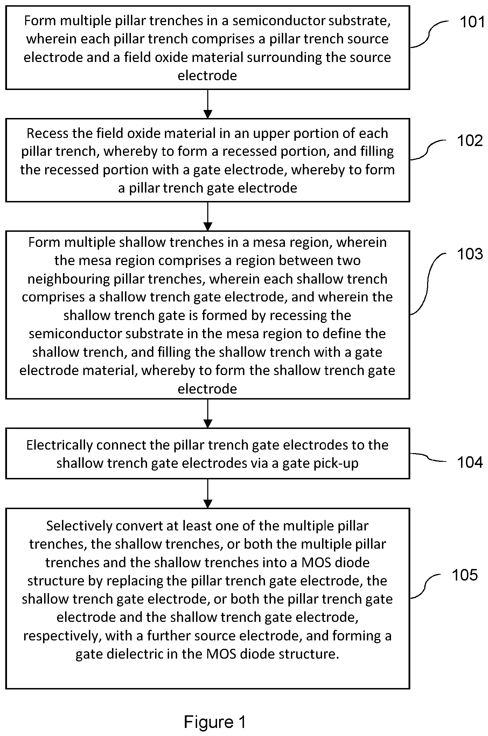

Figure 1 is a flow chart of a method of manufacturing a metal-oxide-semiconductor field-effect transistor (MOSFET). The method comprises, in block 101, forming multiple pillar trenches in a semiconductor substrate, wherein each pillar trench comprises a pillar trench source electrode and a field oxide material surrounding the source electrode. As used herein, the term "pillar trench" refers to a vertically etched trench within the semiconductor substrate that accommodates both a source electrode and surrounding field oxide material, providing a structural and functional component of the MOSFET design. The source electrode in the pillar trench may comprise a conductive material such as doped polysilicon, while the field oxide material may provide electrical isolation. Each pillar trench may comprise a split-gate trench. The split-gate trench may comprise a structure in which the gate is divided into multiple segments, allowing for independent control of different sections of the gate.

In block 102, the method comprises recessing the field oxide material in an upper portion of each pillar trench, whereby to form a recessed portion, and filling the recessed portion with a gate electrode, whereby to form a pillar trench gate electrode. Here, "recessing" refers to the controlled removal of material, such as field oxide, to create a cavity or lowered surface within a defined region of the pillar trench. The gate electrode formed in this recessed portion may comprise conductive materials, such as polysilicon, or metals suitable for gate operations.

The method comprises, in block 103, forming multiple shallow trenches in a mesa region, wherein the mesa region comprises a region between two neighbouring pillar trenches. In other words, the mesa region may refer to the elevated portion of the semiconductor substrate situated between adjacent trenches.

Each shallow trench comprises a shallow trench gate electrode, and wherein the shallow trench gate is formed by recessing the semiconductor substrate in the mesa region to define the shallow trench and filling the shallow trench with a gate electrode material, whereby to form the shallow trench gate electrode. As used herein, the term "shallow trench" may refer to a relatively shallow, horizontally oriented trench formed within the mesa region between neighbouring pillar trenches. The shallow trench gate electrode may comprise the gate electrode material (for example, a polysilicon or a metal) that is deposited into the shallow trench to enable gate operations.

In block 104, the method comprises electrically connecting the pillar trench gate electrodes to the shallow trench gate electrodes via a gate pick-up. The gate pick-up may comprise a conductive structure designed to interconnect gate electrodes and provide electrical continuity across the device. Any suitable shape/design of the gate pick-up may be utilised. In one example, the gate pick-up may comprise a star-shaped gate pick-up, featuring radiating conductive paths resembling a star shape.

The method comprises, in block 105, selectively converting at least one of the multiple pillar trenches, the shallow trenches, or both the multiple pillar trenches and the shallow trenches into a MOS diode structure by replacing the pillar trench gate electrode, the shallow trench gate electrode, or both the pillar trench gate electrode and the shallow trench gate electrode, respectively, with a further source electrode, and forming a gate dielectric in the MOS diode structure. As such, the solution offers a high degree of design freedom, as it enables the choice between converting the split-gate trench, the shallow gate trench, or both into the MOS diode structure. As used herein, the term "MOS diode structure" or "MOS-gated diode" may refer to a unipolar device structure formed by replacing the gate electrode of a trench (pillar or shallow) with a source electrode and introducing a gate dielectric. Advantageously, the MOS diode structure may facilitate current conduction via an inversion channel and offer a lower voltage drop compared to conventional MOSFET body diodes.

A gate dielectric of the MOS-gated diode may be thinner than the gate dielectric in the MOSFET. Furthermore, the thickness of the dielectric in the MOS-gated diode may be tuned in order to achieve a desired voltage drop. The gate dielectric may comprise an insulating layer comprising silicon dioxide, silicon nitride, or other high-k materials, situated between the gate electrode and the underlying substrate.

A contact may be formed to electrically connect the source electrode in the MOS diode structure to a metal layer disposed on the surface of the semiconductor substrate. The contact may comprise a conductive pathway formed using a metal, for example, aluminium, copper, or tungsten.

In response to selectively converting selectively converting at least one of the multiple pillar trenches, the shallow trenches, or both the multiple pillar trenches and the shallow trenches into the MOS diode structure, the star-shaped gate pick-up may be modified by isolating the portions of the gate pick-up corresponding to the converted MOS diode structures. Isolating the portions of the gate pick-up may comprise removing conductive paths (i.e., electrically de-coupling) in the gate pick-up directly above the MOS diode structures and routing the remaining gate pick-up portions to maintain electrical connection only between unconverted gate electrodes of the pillar trench gate electrodes and the shallow trench gate electrodes.

The method may further comprise forming a gate dielectric forming a gate dielectric along sidewalls of the recessed portion of each pillar trench and sidewalls of each shallow trench prior to filling with the gate electrode, wherein the gate dielectric within the MOS diode structure is thinner than the gate dielectric of the multiple pillar trenches and the multiple shallow trenches.

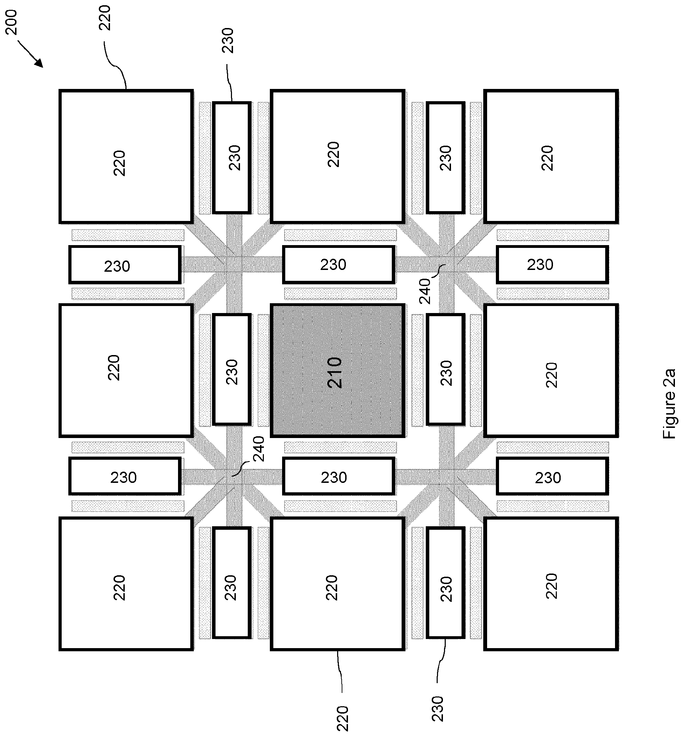

Figure 2a is a schematic representation of a metal-oxide-semiconductor field-effect transistor according to a first example. In this example, the MOSFET 200 includes multiple pillar trenches (SGT) 220 and shallow gate trenches 230, interconnected via a star-shaped gate pick-up 240. Notably, one of the pillar trenches 220 is converted into a MOS diode structure (MGD) 210 by replacing its gate electrode 221 with a source electrode 212. In order to reduce the voltage drop, the gate dielectric in the MOS diode structure (Tox3) may be thinner than the gate dielectrics (Tox1, Tox2, Tox4) in other regions.

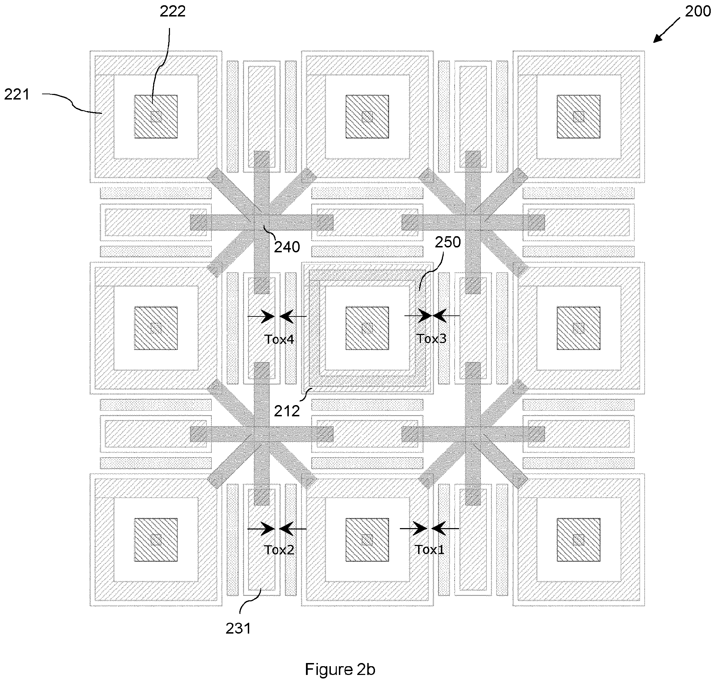

Figure 2b is another schematic representation of a metal-oxide-semiconductor field-effect transistor according to a first example. In particular, Figure 2b illustrates the star-shaped gate pick-up 240 interconnecting the pillar trench gate electrodes 221 and shallow gate trench electrodes 231, while also showing the electrical separation between the MOS diode structure source electrode 212 and the remaining gate network to prevent gate-to-source shorting.

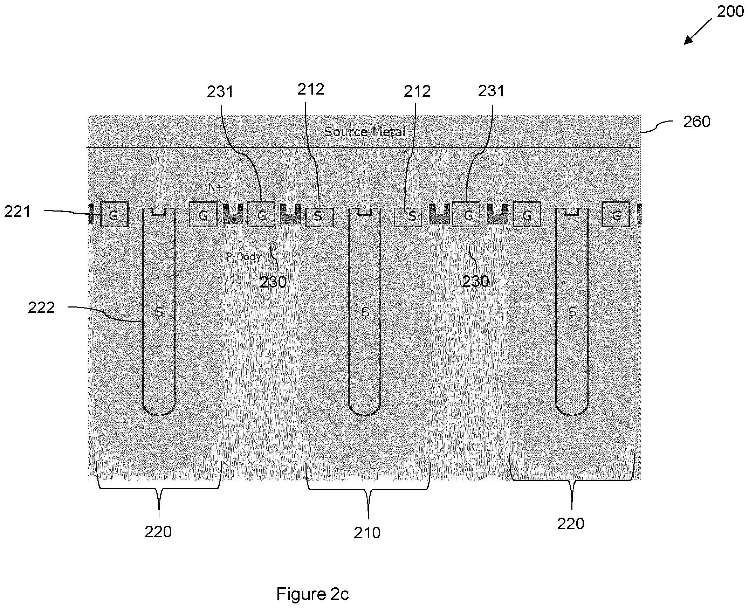

Figure 2c is a cross-section view of a metal-oxide-semiconductor field-effect transistor according to a first example. This figure shows the detailed structure of the pillar trench 220, shallow gate trench 230, and their corresponding electrodes. The pillar trench 220 features a pillar trench gate electrode 221 and a pillar trench source electrode 222 surrounded by thick field oxide, while the MOS diode structure 210 is created by recessing the thick field oxide and replacing the pillar trench gate electrode 221 with an MOS diode structure source electrode 212. The source contact 250 (shown in Figure 2b) may connect the MOS diode structure source electrode 212 to the source metal 260 at the top, providing electrical connectivity.

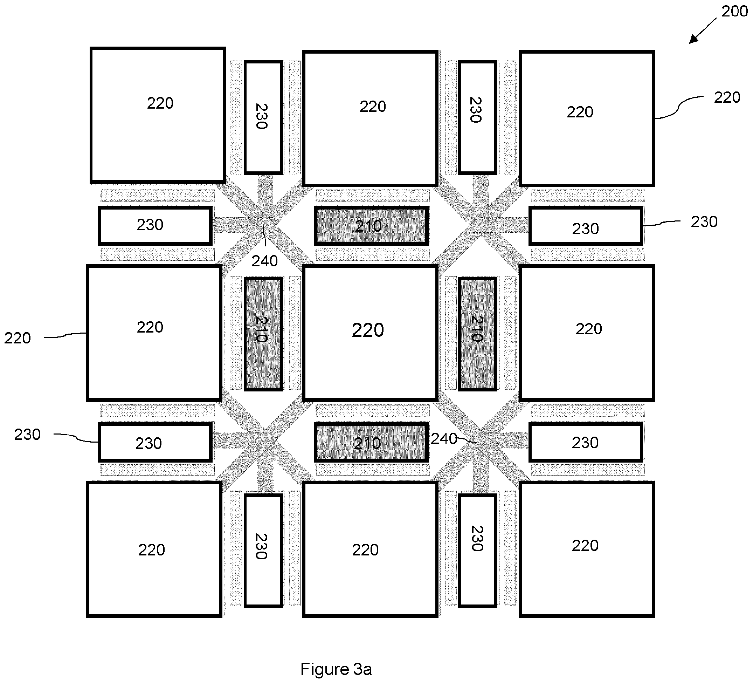

Figure 3a is a schematic representation of a metal-oxide-semiconductor field-effect transistor according to a second example.

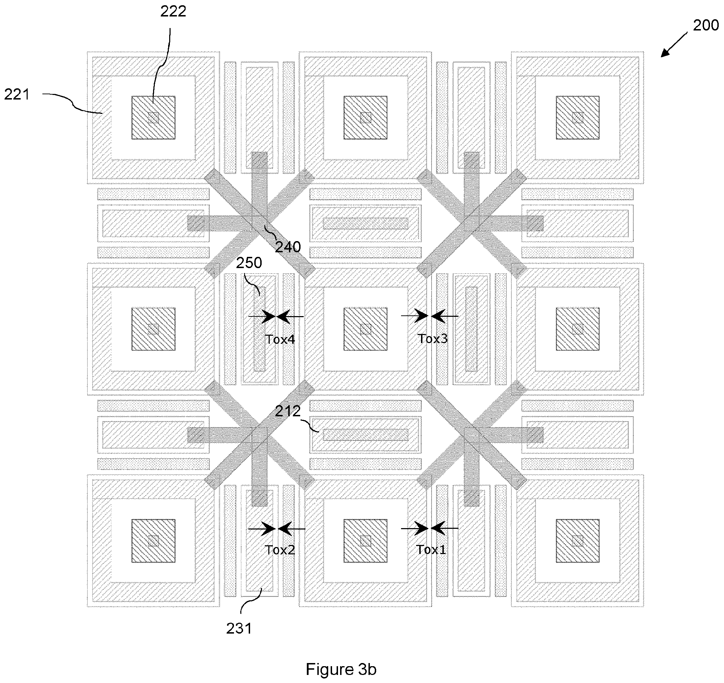

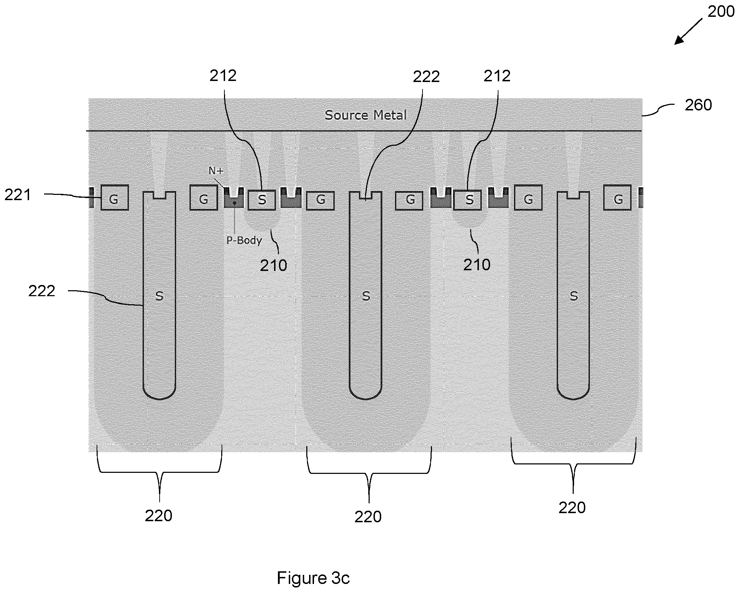

The same reference numerals are used in Figures 2 and 3 to refer to the same elements, functioning likewise between the two figures. In contrast to Figure 2a, Figure 3a depicts the scenario in which at least one of the shallow gate trenches 230 is converted into a MOS diode structure 210. In particular, in Figure 3a, all of the shallow gate trenches 230 are converted into MOS diode structures 210, but the invention is not limited thereto. In this configuration, the shallow gate trench electrode 231 in the mesa region between two pillar trenches 220 is replaced with a MOS diode structure source electrode 212. Similarly to Figure 2, in Figure 3, to reduce the voltage drop, the gate dielectric in the MOS diode structure 210 (Tox4, compared to Tox3 used in Figure 2) is thinner than the typical gate dielectrics (Tox1, Tox2, Tox3).

Figure 3b is another schematic representation of a metal-oxide-semiconductor field-effect transistor according to a second example. In particular, Figure 3b focuses on the star-shaped gate pick-up 240 interconnecting the pillar trench gate electrodes 221 and the shallow gate trench electrodes 231, while showing the electrical separation between the MOS diode structure source electrode 212 and the gate network. Importantly, compared to Figure 2b, the design of the star-shaped gate pick-up 240 differs to accommodate the location of the MOS diode structures 210, so that shorting between the gate and source can be prevented.

Figure 3c is a cross-section view of a metal-oxide-semiconductor field-effect transistor according to a second example. Figure 3c depicts the detailed structure of the shallow gate trench 230 converted into the MOS diode structure 210. After forming the shallow trench in the mesa region between two pillar trenches 220, the trench may be filled with a MOS diode structure source electrode 212. A source contact 250 may be used to connect the MOS diode structure source electrode 212 in the shallow trench to the source metal 260 at the top.

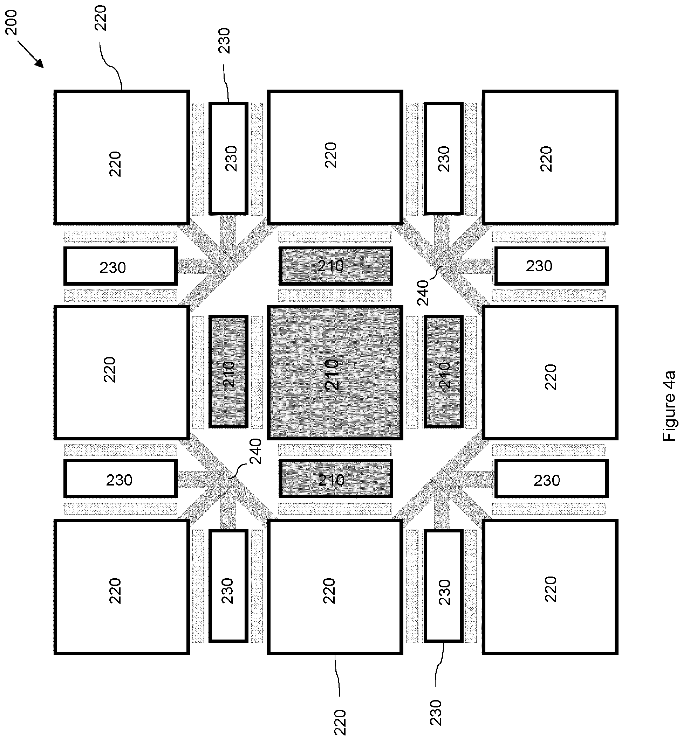

Figure 4a is a schematic representation of a metal-oxide-semiconductor field-effect transistor according to a third example. The same reference numerals are used in Figures 2, 3, and 4 to refer to the same elements, functioning in a similar manner across all the examples. The embodiment shown in Figure 4a depicts the scenario in which both a pillar trench 220 and the neighbouring shallow gate trenches 230 are converted into MOS diode structures 210. The pillar trench gate electrode 221 and the shallow gate trench electrodes 231 in the vicinity of the pillar trench are replaced with MOS diode structure source electrodes 212. All of the elements may be connected to the source metal 260. Similarly to the embodiments described above in relation to Figures 2 and 3, the gate dielectrics in the MOS diode structure regions (Tox3 and Tox4) may be thinner than the typical gate dielectrics in MOSFET regions (Tox1 and Tox2) to reduce the voltage drop.

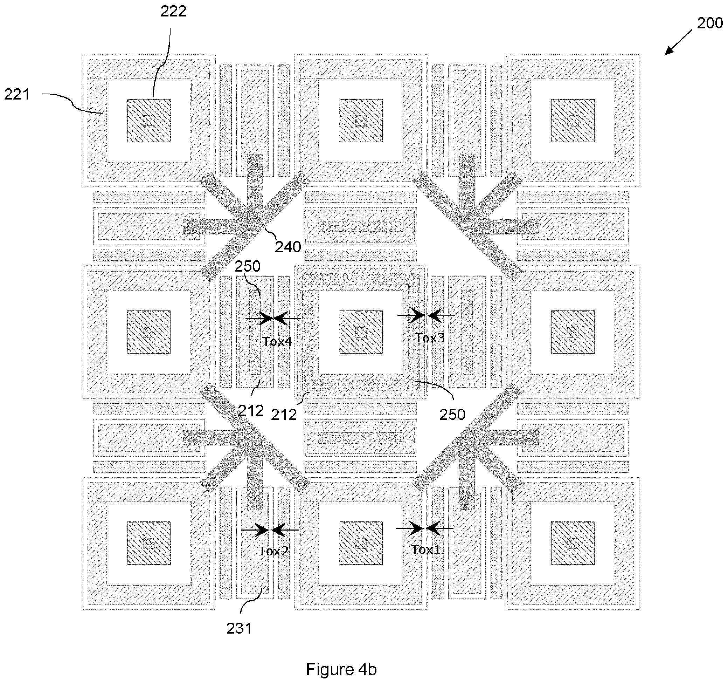

Figure 4b is another schematic representation of a metal-oxide-semiconductor field-effect transistor according to a third example. Figure 4b shows the star-shaped gate pick-up 240 interconnecting the pillar trench gate electrodes 221 and the shallow gate trench electrodes 231 while ensuring electrical isolation between the MOS diode structure source electrodes 212 and the gate network. Compared to Figures 2 and 3, the star-shaped gate pick-up 240 of Figure 4b is redesigned to prevent any shorting between the gate and source.

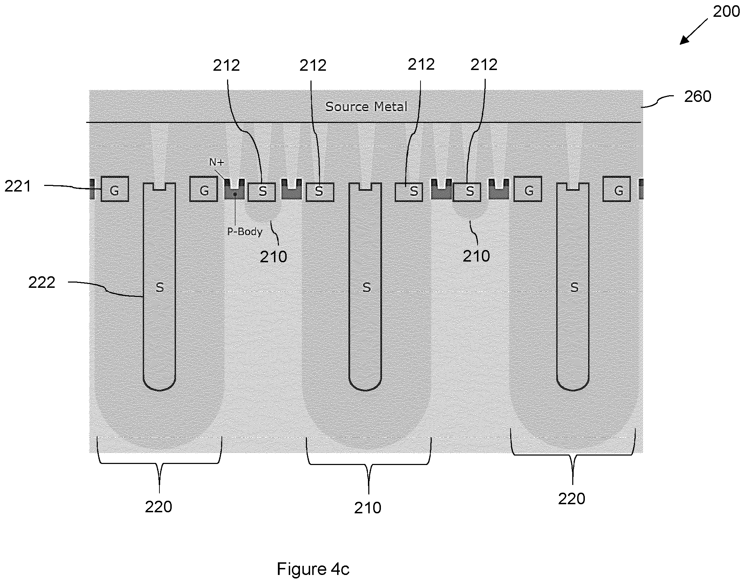

Figure 4c is a cross-section view of a metal-oxide-semiconductor field-effect transistor according to a third example. The cross-section depicts the conversion of a pillar trench 220 and neighbouring shallow gate trenches 230 into MOS diode structures 210. Both the source electrode 222 in the upper part of the pillar trench and the source electrodes in the neighbouring shallow trenches may be connected to the source metal 260 using source contacts 250. In order to create the MOS diode structures 210, after forming the pillar trench 220 and neighbouring shallow gate trenches 230, both the pillar trench and the shallow gate trenches may be filled with source electrodes, creating the MOS diode structures 210.

Advantageously, the solution described herein offers a more accurate, more precise design in scenarios where the absolute needed quantity of MOS diode is designed. The design described herein offers a much smaller ON-resistance penalty compared to solutions available in the prior art. Furthermore, by parallelling the MOSFET(s) and the MOS-gated diode, the voltage drop across the body diode can be reduced, thus minimising reverse recovery losses. The solution described herein offers an uncomplicated layout and makes efficient use of the die area. Despite these advantages, the resulting design does not cause an increase in process complexity of the manufacturing.

The preceding description has been provided to enable others skilled in the art to best utilize various aspects of the exemplary embodiments disclosed herein. This exemplary description is not intended to be exhaustive or to be limited to any precise form disclosed. Many modifications and variations are possible without departing from the spirit and scope of the instant disclosure. The embodiments disclosed herein should be considered in all respects illustrative and not restrictive. Reference should be made to the appended claims and their equivalents in determining the scope of the instant disclosure.

## Claims

1. A method of manufacturing a metal-oxide-semiconductor field-effect transistor, MOSFET, the method comprising:
forming multiple pillar trenches in a semiconductor substrate, wherein each pillar trench comprises a pillar trench source electrode and a field oxide material surrounding the source electrode (101);
recessing the field oxide material in an upper portion of each pillar trench, whereby to form a recessed portion, and filling the recessed portion with a gate electrode, whereby to form a pillar trench gate electrode (102);
forming multiple shallow trenches in a mesa region, wherein the mesa region comprises a region between two neighbouring pillar trenches, wherein each shallow trench comprises a shallow trench gate electrode, and wherein the shallow trench gate is formed by recessing the semiconductor substrate in the mesa region to define the shallow trench, and filling the shallow trench with a gate electrode material, whereby to form the shallow trench gate electrode (103); electrically connecting the pillar trench gate electrodes to the shallow trench gate electrodes via a gate pick-up (104); selectively converting at least one of the multiple pillar trenches, the shallow trenches, or both the multiple pillar trenches and the shallow trenches into a MOS diode structure by:
replacing the pillar trench gate electrode, the shallow trench gate electrode, or both the pillar trench gate electrode and the shallow trench gate electrode, respectively, with a further source electrode; and
forming a gate dielectric in the MOS diode structure (105).

2. The method of claim 1, wherein the gate pick-up comprises a star-shaped gate pick-up.

3. The method of claim 2, further comprising, in response to selectively converting at least one of the multiple pillar trenches, the shallow trenches, or both the multiple pillar trenches and the shallow trenches into the MOS diode structure (105), modifying the star-shaped gate pick-up by isolating the portions of the gate pick-up corresponding to the converted MOS diode structures, wherein isolating the portions of the gate pick-up comprises removing conductive paths in the gate pick-up directly above the MOS diode structures; and routing the remaining gate pick-up portions to maintain electrical connection only between unconverted gate electrodes of the pillar trench gate electrodes and the shallow trench gate electrodes.

4. The method of any one of claims 1 to 3, further comprising:
forming a gate dielectric along sidewalls of the recessed portion of each pillar trench and sidewalls of each shallow trench prior to filling with the gate electrode,
wherein the gate dielectric within the MOS diode structure is thinner than the gate dielectric of the multiple pillar trenches and the multiple shallow trenches.

5. The method of claim 4, further comprising adjusting a thickness of the gate dielectric within the MOS diode structure, whereby to achieve a specific voltage drop across a body junction of the MOS diode structure.

6. The method of any one of claims 1 to 5, further comprising forming a contact to electrically connect the source electrode in the MOS diode structure to a metal layer disposed on the surface of the semiconductor substrate

7. A metal-oxide-semiconductor field-effect transistor (200), MOSFET, comprising:
multiple pillar trenches (220), wherein each of the multiple pillar trenches (220) comprises a source electrode (222) surrounded by field oxide and a recessed upper portion comprising a pillar trench gate electrode (221);
a mesa region comprising a region between two neighbouring pillar trenches of the multiple pillar trenches (220), wherein the mesa region comprises multiple shallow trenches (230), wherein each shallow trench (230) of the multiple shallow trenches (230) comprises a shallow trench gate electrode (231);
a gate pickup (240) arranged to electrically connect each one of the pillar trench gate electrodes (221) to the shallow trench gate electrodes (231),
wherein at least one of the multiple pillar trenches (220), the shallow trenches (230), or both the multiple pillar trenches (220) and the shallow trenches (230) comprises a MOS diode structure (210), wherein each of the MOS diode structures (210) comprises:
a source electrode (212) in place of: the pillar trench gate electrode, the shallow trench gate electrode, or both the pillar trench gate electrode and the shallow trench gate electrode, respectively; and
a gate dielectric.

8. The MOSFET of claim 7, wherein the MOS diode structure (210) is electrically connected in parallel to the multiple pillar trenches (220) and the multiple shallow trenches (230).

9. The MOSFET of claim 7 or 8, further comprising a gate dielectric disposed along the sidewalls of the recessed portion of each pillar trench (220) and along the sidewalls of each shallow trench (230), wherein the gate dielectric within the MOS diode structure (210) is thinner than the gate dielectric in the multiple pillar trenches (220) and the multiple shallow trenches (230).

10. The MOSFET of any one of claims 7 to 9, wherein a threshold voltage of the MOS diode structure (210) is lower than a threshold voltage of the multiple pillar trenches (220) and the multiple shallow trenches (230).

11. The MOSFET of any one of claims 7 to 10, wherein the gate pick-up (240) comprises a star-shaped gate pick-up.

12. The MOSFET of any one of claims 7 to 11, wherein each pillar trench (220) comprises a split-gate structure, the split-gate structure comprising:
a first gate region positioned along a first sidewall of the pillar trench; and
a second gate region positioned along an opposing sidewall of the pillar trench,
wherein the first and second gate regions are independently controllable to form separate conductive channels along the respective sidewalls, thereby providing dual-gate control over a current flow through the pillar trench (220).

13. The MOSFET of any one of claims 7 to 12, further comprising a contact electrically connecting the source electrode in each MOS diode structure (210) to a metal layer (260) disposed on a surface of the semiconductor substrate, wherein the metal layer (260) forms a source terminal for the MOSFET.

14. The MOSFET of any one of claims 7 to 13, wherein the MOS diode structure (210) is formed by converting at least one of the multiple pillar trenches (220), at least one of the multiple shallow trenches (230) or both the multiple pillar trenches (220) and the multiple shallow trenches (230) into a MOS-gated diode.

15. A chip system comprising:
a plurality of MOSFETs according to any one of claims 7 to 14,
wherein the pillar trenches and/or the shallow gate trenches in some or all of the MOSFETs comprise MOS diode structures.
